# EUROPEAN PATENT APPLICATION

(11) **EP 4 773 756 A1**
(43) Date of publication of application: **08.07.2026**
(21) Application number: 25213595.9
(22) Date of filing: 05.11.2025
(51) Int. Cl.: H10F 10/14, H10F 10/165, H10F 19/90, H10F 77/20, H10F 77/30

(54) **PHOTOVOLTAIC MODULE**

(30) Priority: 03.01.2025 CN 202510007330
(71) Applicant: Zhejiang Jinko Solar Co., Ltd., Haining, Zhejiang 314416 (CN)
(72) Inventor: YANG, Jie, HAINING, 314416 (CN); YU, Linglin, HAINING, 314416 (CN); ZHANG, Yuanfang, HAINING, 314416 (CN); WANG, Zhao, HAINING, 314416 (CN); ZHENG, Peiting, HAINING, 314416 (CN); ZHANG, Xinyu, HAINING, 314416 (CN)
(74) Representative: Rösler Rasch van der Heide & Partner

(57) **Abstract**

The present disclosure provides a photovoltaic module, including a cell string. The cell string includes cells, including an N-type silicon substrate which includes a first side and a second side. The first side includes a first region and a second region distributed alternately. The first region is provided with a boron-doped silicon structure. The second side includes a third region and a fourth region distributed alternately. The third region is provided with a tunneling oxide layer and a phosphorus-doped conductive layer. The cell includes a first surface and a second surface, and includes a first electrode disposed on the first surface and a second electrode disposed on the second surface. A plurality of first cells and a plurality of second cells are disposed alternately. The first surface of the first cell and the second surface of the second cell are located on a same side. The first electrode of the first cell is connected to the second electrode of the adjacent second cell through a solder strip. The second electrode of the first cell is connected to the first electrode of the adjacent second cell through the solder strip. Such an arrangement improves the photoelectric conversion efficiency and the output power of the photovoltaic module.

## Description

### TECHNICAL FIELD

The present disclosure relates to the technical field of photovoltaic, and in particular, to a photovoltaic module.

### BACKGROUND

Solar energy is an inexhaustible renewable energy source for humanity. A photovoltaic module is not only a core component but also the most critical part of a solar power generation system, and functions to convert solar energy into electric energy and send the electric energy to a storage battery for storage or power a load. The photovoltaic module typically includes a cell string composed of cells connected in series.

In an existing cell string, a spacing between two adjacent cells is relatively large, resulting in a relatively small power generation per unit area of the photovoltaic module and an issue of low photoelectric conversion efficiency.

### SUMMARY

In view of this, the present disclosure provides a photovoltaic module, so as to resolve the issue of relatively low photoelectric conversion efficiency of the photovoltaic module in the related art. The invention is set out in the appended set of claims.

An embodiment of the present disclosure provides a photovoltaic module, including a cell string. The cell string includes cells, the cells include an N-type silicon substrate, the N-type silicon substrate includes a first side and a second side oppositely distributed along a thickness direction of the N-type silicon substrate, the first side includes a first region and a second region distributed alternately, the first region is provided with a boron-doped silicon structure, the second side includes a third region and a fourth region distributed alternately, and the third region is provided with a tunneling oxide layer and a phosphorus-doped conductive layer distributed in a stacked manner. One of the cells includes a first surface and a second surface oppositely distributed along a thickness direction of the cell, one of the cells includes a first electrode disposed on the first surface, and the first electrode is only located in the first region and electrically connected to the boron-doped silicon structure; one of the cells further includes a second electrode disposed on the second surface, and the second electrode is only located in the third region and electrically connected to the phosphorus-doped conductive layer. The cells include first cells and second cells, the first cells and the second cells are alternately disposed along a length direction of the cell string, and along a thickness direction of the cell string, first surfaces of the first cells and second surfaces of the second cells are located on a same side. The cell string further includes a solder strip, the first electrode of one of the first cells is electrically connected to the second electrode of one of the second cell adjacent thereto through the solder strip, and the second electrode of one of the first cells is electrically connected to the first electrode of one of the second cells adjacent thereto through the solder strip.

In an embodiment, a spacing between each first cell and a second cell adjacent thereto is smaller than 1mm.

In an embodiment, the solder strip includes a plurality of first solder strips spaced apart along the length direction of the cell string, and the first electrode of one of the first cells is connected to the second electrode of one of the second cells adjacent thereto through the first solder strip; and the solder strip further includes a plurality of second solder strips spaced apart along the length direction of the cell string, and the second electrode of one of the first cells is connected to the first electrode of one of the second cells adjacent thereto through the second solder strip.

In an embodiment, the first electrode includes a first busbar and a first finger, and the second electrode includes a second busbar and a second finger; an extension direction of the first solder strip is parallel to an extension direction of the first busbar and the second busbar, and the first solder strip is configured to connect the first busbar of the first cell and the second busbar of the second cell adjacent thereto; and an extension direction of the second solder strip is parallel to the extension direction of the first busbar and the second busbar, and the second solder strip is configured to connect the second busbar of the first cell and the first busbar of the second cell adjacent thereto.

In an embodiment, the cell is a busbar-free cell, the first electrode includes a first finger, and the second electrode includes a second finger; an extension direction of the first solder strip is perpendicular to an extension direction of the first finger and the second finger, and the first solder strip is configured to connect the first finger of the first cell and the second finger of the second cell adjacent thereto; and an extension direction of the second solder strip is perpendicular to the extension direction of the first finger and the second finger, and the second solder strip is configured to connect the second finger of the first cell and the first finger of the second cell adjacent thereto.

In an embodiment, the phosphorus-doped conductive layer is one of a phosphorus-doped amorphous silicon layer, a phosphorus-doped monocrystalline silicon layer, or a phosphorus-doped polycrystalline silicon layer.

In an embodiment, the first surface is configured as a textured structure; and/or, the second surface is configured as a textured structure.

In an embodiment, the cell further includes a first passivation layer and a first anti-reflection layer, the first passivation layer is disposed on a side of the boron-doped silicon structure away from the N-type silicon substrate and located in the second region, and the first anti-reflection layer is disposed on a side of the first passivation layer away from the N-type silicon substrate.

In an embodiment, the cell further includes a second passivation layer and a second anti-reflection layer, the second passivation layer is disposed on a side of the phosphorus-doped conductive layer away from the tunneling oxide layer and located in the fourth region, and the second anti-reflection layer is disposed on a side of the second passivation layer away from the N-type silicon substrate.

In an embodiment, the photovoltaic module further includes: an encapsulation layer configured to cover a surface of the cell string; and a cover plate configured to cover a surface of the encapsulation layer away from the cell string.

In the present disclosure, the cells in the cell string are disposed with their front and back surfaces in an alternate manner, enabling the solder strip to connect two adjacent cells via same-side interconnection, thereby reducing the cell spacing between adjacent cells in the cell string, allowing an increase in the number of cells in the cell string without increasing the area of the photovoltaic module, reducing the blank area in the layout of the photovoltaic module, improving the light-receiving area of the cell string per unit area, thus improving the power generation per unit area of the photovoltaic module and further improving the photoelectric conversion efficiency and the output power of the photovoltaic module. Additionally, the cell in the present disclosure adopts a special structure in which the first region is provided with the boron-doped silicon structure and the third region is provided with the phosphorus-doped layer conductive layer, enabling the bifacial ratio of the cells to approach 100%, thereby further improving the photoelectric conversion efficiency of the photovoltaic module, and thus improving the output power of the photovoltaic module. Additionally, the use of same-side interconnection for the solder strip may also avoid the bending of the solder strip, reduce the risk of the detachment of the solder strip, and lower the risk of stress concentration between the solder strip and an edge of the cell, which is beneficial to improving the reliability of the photovoltaic module and prolonging the service life of the photovoltaic module.

It should be understood that the general description above and the detailed description in the following are merely illustrative, and cannot limit the present disclosure.

### BRIEF DESCRIPTION OF DRAWINGS

In order to better illustrate the technical solutions in embodiments of the present disclosure, the drawings used in the description of embodiments are briefly described as below. It will be apparent that the drawings described below are merely some embodiments of the present disclosure, and other drawings may be obtained by those skilled in the art according to these drawings without paying any creative efforts.
FIG. 1 is a structural schematic diagram of a photovoltaic module according to one or more embodiments of the present disclosure;
FIG. 2 is a cross-sectional diagram of a cell in FIG. 1;
FIG. 3 is a structural schematic diagram of a cell string in FIG. 1 in an embodiment;
FIG. 4 is a top view of the cell string in FIG. 3;

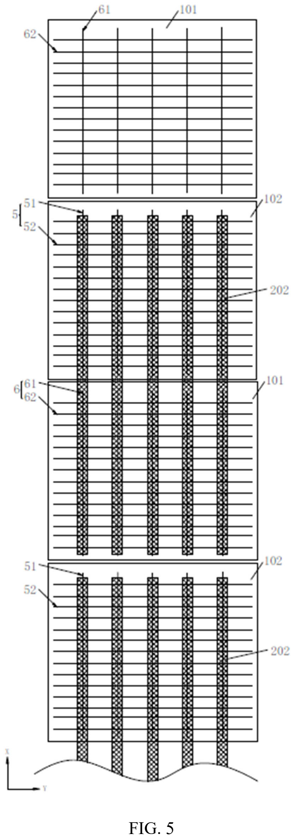

FIG. 5 is a bottom view of the cell string in FIG. 3;

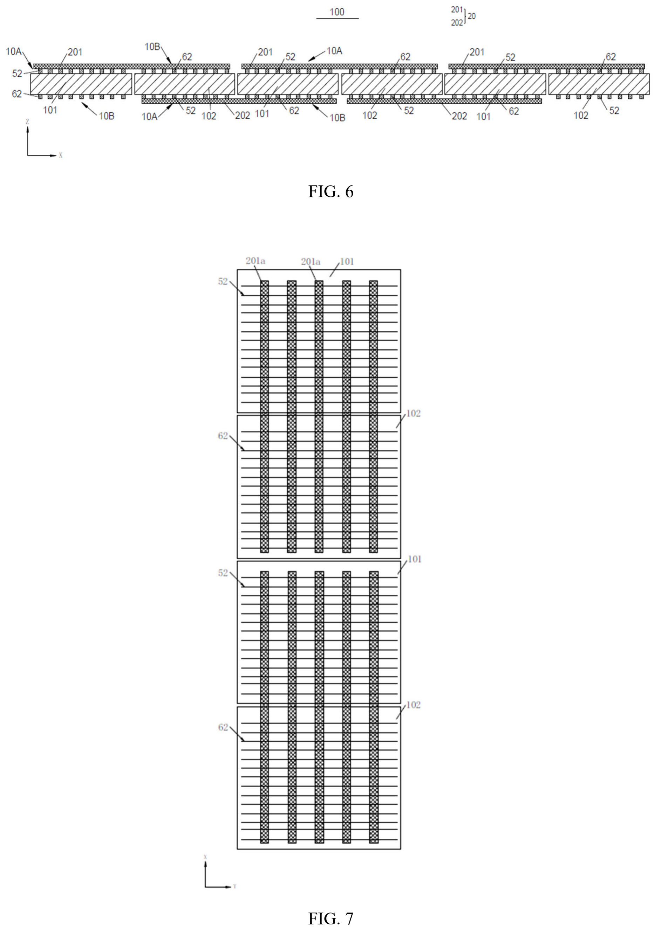

FIG. 6 is a structural schematic diagram of a cell string in FIG. 1 in another embodiment;
FIG. 7 is a top view of the cell string in FIG. 6; and

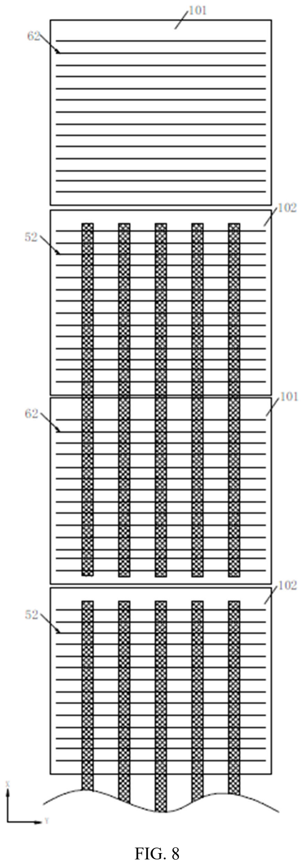

FIG. 8 is a bottom view of the cell string in FIG. 6.

Reference signs:
100 - cell string;
200 - encapsulation layer;
300 - cover plate;
10 - cell;
   10A - first surface;
   10B - second surface;
   10a - first region;
   10b - second region;
   10c - third region;
   10d - fourth region;
   101 - first cell;
   102 - second cell;
20 - solder strip;
   201 - first solder strip;
   202 - second solder strip;
1 - N-type silicon substrate;
   1a - a first side;
   1b - a second side;
2 - boron-doped silicon structure;
3 - phosphorus-doped conductive layer;
4 - tunneling oxide layer;
5 - first electrode;
   51 - first busbar;
   52 - first finger;
6 - second electrode;
   61 - second busbar;
   62 - second finger;
7a - first anti-reflection layer;
7b - first passivation layer;
8a - second anti-reflection layer;
8b - second passivation layer

### DESCRIPTION OF EMBODIMENTS

In order to better illustrate the technical solutions of the present disclosure, embodiments of the present disclosure are described in detail below in conjunction with the drawings.

It should be clear that the described embodiments are only some rather than all of embodiments of the present disclosure. All other embodiments obtained by those skilled in the art without creative efforts according to embodiments of the present disclosure are within the protection scope of the present disclosure.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

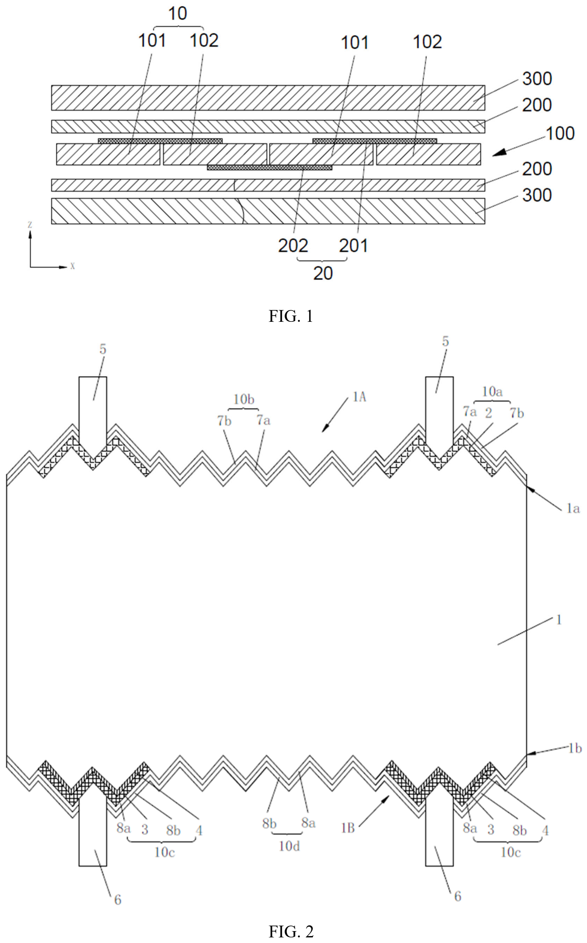

An embodiment of the present disclosure provides a photovoltaic module. As shown in FIG. 1, the photovoltaic module includes a cell string 100, an encapsulation layer 200, and a cover plate 300. The encapsulation layer 200 is configured to cover two side surfaces of the cell string 100 in a thickness direction Z of the photovoltaic module. The cover plate 300 is configured to cover a surface of the encapsulation layer 200 away from the cell string 100. The encapsulation layer 200 may be an organic encapsulation film such as an ethylene-vinyl acetate copolymer (EVA) adhesive film, a polyethylene octene co-elastomer (POE) adhesive film, a polyethylene terephthalate (PET) adhesive film, or polyvinyl butyral (PVB). The cover plate 300 may be a transparent cover plate such as a glass cover plate or a plastic cover plate. The surface of the cover plate 300 facing the encapsulation layer 200 may be an uneven surface, thereby increasing the utilization rate of incident light. The encapsulation layer 200 and the cover plate 300 can ensure that the photovoltaic module has good mechanical strength and reduce the influence caused by conditions such as hail impact, wind exposure, and mechanical vibration. Additionally, the encapsulation process can improve the sealing performance of the photovoltaic module, thereby improving the erosion resistance and safety of the photovoltaic module.

The photovoltaic module includes cell strings 100 electrically connected in series and/or in parallel. Each cell string 100 includes cells 10 connected in series via a solder strip 20. The cell 10 may be a whole cell, a half-cut cell, a three-cut cell, or a segmented cell in another form, which is not limited in this embodiment.

The structure of the cell 10 in this embodiment is shown in FIG. 2, the cell 10 includes an N-type silicon substrate 1, and the N-type doping element in the N-type silicon substrate 1 may specifically be one or a combination of pentavalent elements such as phosphorus, arsenic or antimony. The N-type silicon substrate 1 includes a first side 1a and a second side 1b that are opposite to each other along a thickness direction Z of the N-type silicon substrate 1. The first side 1a may be a light-facing side of the N-type silicon substrate 1, that is, a side surface facing the light source and configured to receive direct sunlight. The second side 1b may be a backlight side of the N-type silicon substrate, that is, a side surface facing away from the light source and configured to receive sunlight reflected by the ground. Both the first side 1a and the second side 1b can receive sunlight and convert light energy into electric energy.

The first side 1a includes a first region 10a and a second region 10b distributed alternately. The first region 10a may be a metalized region of the light-facing side. That is, the first region 10a is a region where a metal electrode line of the light-facing side is located. For those skilled in the art, an actual width of the first region 10a may be greater than that of the metal electrode line. The second region 10b may be a non-metallized region of the light-facing side. That is, the second region 10b is a region of the first side 1a excluding the first region 10a. The first side 1a is provided with a boron-doped silicon structure 2. The boron-doped silicon structure 2 and the N-type silicon substrate 1 have different types of doping elements. As an emitter, the boron-doped silicon structure 2 may form a PN junction with the N-type silicon substrate 1. Therefore, the injection efficiency of the photo-generated minority carriers may be improved, thereby improving the open-circuit voltage of the cell 10, increasing the short-circuit current of the cell 10, and thus improving the photoelectric conversion efficiency of the cell 10. Additionally, doping the polycrystalline silicon layer with boron can improve its high-temperature resistance, ensuring that the cell 10 maintains excellent electrical properties during the high-temperature annealing process, enhancing the long-term stability of the polycrystalline silicon layer, and thus being beneficial to improving the reliability of the cell 10 and prolonging the service life of the cell 10. As shown in FIG. 2, the boron-doped silicon structure 2 is only disposed in the first region 10a, thereby reducing parasitic absorption of the incident light by the second region 10b, thus improving the absorption rate of the incident light by the first side 1a and further improving the efficiency of the light-facing side of the cell 10.

As shown in FIG. 2, along the thickness direction Z of the N-type silicon substrate 1, a first passivation layer 7a is further disposed on a surface of the boron-doped silicon structure 2 away from the N-type silicon substrate 1. A first anti-reflection layer 7b is further disposed on a surface of the first passivation layer 7a away from the boron-doped silicon structure 2. The second region 10b is also provided with a first passivation layer 7a and a first anti-reflection layer 7b stacked along the thickness direction Z of the N-type silicon substrate 1. A side surface of the first passivation layer 7a away from the first anti-reflection layer 7b covers the first side 1a. The first passivation layer 7a (the first passivation layer 7a on a surface of the boron-doped silicon structure 2) in the first region 10a and the first passivation layer 7a in the second region 10b may be an integrated structure. The first anti-reflection layer 7b in the first region 10a and the first anti-reflection layer 7b in the second region 10b may also be an integrated structure. The first passivation layer 7a may include at least one of silicon nitride, silicon oxynitride, titanium oxide, and aluminum oxide, which can provide an excellent passivation function, increase the carrier concentration on the first side 1a, and improve the short-circuit current and open-circuit voltage of the cell 10, thereby improving the photoelectric conversion efficiency of the cell. The first anti-reflection layer 7b may reduce light reflection and improve an incidence rate of light incident on the first side 1a by using the thin film interference principle. The first anti-reflection layer 7b may be a silicon oxide layer or an aluminum oxide layer.

The second side 1b includes a third region 10c and a fourth region 10d distributed alternately. The third region 10c may be the metalized region of the backlight side. That is, the third region 10c is a region where the metal electrode line of the backlight side is located. For those skilled in the art, the actual width of the third region 10c may be larger than that of the metal electrode line. The fourth region 10d may be a non-metallized region of the backlight side. That is, the fourth region 10d is a region of the second side 1b excluding the third region 10c. Along a direction of the thickness direction Z of the N-type silicon substrate 1 towards away from the silicon substrate 1, a tunneling oxide layer 4 and a phosphorus-doped conductive layer 3 are sequentially disposed in the third region 10c. The tunneling oxide layer 4 and the phosphorus-doped conductive layer 3 that are stacked may form a passivation contact structure, which may improve the efficiency of electron collection by the phosphorus-doped conductive layer 3. In one or more embodiments, the tunneling oxide layer 4 may include at least one of silicon oxide, aluminum oxide, silicon nitride, silicon oxynitride, silicon carbide or magnesium fluoride, amorphous silicon and polysilicon. The lattice of the tunneling oxide layer 4 may be well matched with the lattice of the N-type silicon substrate 1, thereby providing chemical passivation for a portion of the second side 1b located in the third region 10c, reducing the recombination center of the contact surface between the tunneling oxide layer 4 and the N-type silicon substrate 1, and thus reducing the recombination rate of carriers on the contact surface between the N-type silicon substrate 1 and the tunneling oxide layer 4. The phosphorous-doped conductive layer 3 may be one of a phosphorous-doped amorphous silicon layer, a phosphorous-doped monocrystalline silicon layer or a phosphorous-doped polycrystalline silicon layer, and is configured to form a field passivation layer on the second side 1b, thereby reducing a minority carrier concentration and realizing selective transmission of majority carriers, further reducing a carrier recombination rate, improving a voltage of the cell 10, and increasing a short-circuit current of the cell 10, and thus improving photoelectric conversion efficiency of the cell 10. Additionally, doping the conductive layer with phosphorus may enhance the long-term stability of the doped conductive layer, thereby facilitating improving the reliability of the cell 10 and prolonging the service life of the cell 10. As shown in FIG. 2, the phosphorus-doped conductive layer 3 and the tunneling oxide layer 4 are only disposed in the third region 10c, thereby reducing parasitic absorption of the incident light by the fourth region 10d, thus improving the absorption rate of the incident light by the second side 1b and further improving the efficiency of the backlight side of the cell 10.

As shown in FIG. 2, along the thickness direction Z of the N-type silicon substrate 1, a second passivation layer 8a is further disposed on a surface of the phosphorus-doped conductive layer 3 away from the tunneling oxide layer 4. A second anti-reflection layer 8b is further disposed on a surface of the second passivation layer 8a away from the phosphorus-doped conductive layer 3. The fourth region 10d is also provided with a second passivation layer 8a and a second anti-reflection layer 8b stacked along the thickness direction Z of the N-type silicon substrate 1. A side surface of the second passivation layer 8a away from the second anti-reflection layer 8b covers the second side 1b. The second passivation layer 8a (the second passivation layer 8a on a surface of the phosphorus-doped conductive layer 3) in the third region 10c and the second passivation layer 8a in the fourth region 10d may be an integrated structure. The second anti-reflection layer 8b in the third region 10c and the second anti-reflection layer 8b in the fourth region 10d may also be an integrated structure. The second passivation layer 8a may include at least one of silicon nitride, silicon oxynitride, titanium oxide, and aluminum oxide, which can provide an excellent passivation function, increase the carrier concentration on the second side 1b, and improve the short-circuit current and open-circuit voltage of the cell 10, thereby improving the photoelectric conversion efficiency of the cell. The second anti-reflection layers 8b may reduce light reflection and improve an incidence rate of light incident on the second side 1b by using the thin film interference principle. The second anti-reflection layer 8b may be a silicon oxide layer or an aluminum oxide layer.

In one or more embodiments, the first side 1a and/or the second side 1b are/is configured as a textured structure. When the first side 1a is of a pyramid-shaped textured structure, the reflectivity of the first side 1a to the incident light may be reduced and the light absorption efficiency of the first side 1a may be improved, thereby improving light transmittance of the first side 1a and further improving the photoelectric conversion efficiency of the cell 10. Similarly, when the second side 1b is of a pyramid textured structure, the reflectivity of the second side 1b to the incident light may be reduced and the light absorption efficiency of the second side 1b may be improved, thereby improving the photoelectric conversion efficiency of the cell 10 and further improving the bifaciality of the cell 10. Additionally, the texturing process can enhance the mechanical strength and durability of the N-type silicon substrate 1 and reduce the performance degradation caused by surface defects, thereby improving the long-term stability and reliability of the cell 10.

Additionally, if only the first side 1a is textured, a front surface of the cell 10 may be matte dark blue or blue-black, while a back surface of the cell 10 may appear reflective light blue. If the cells 10 in the photovoltaic module are alternately disposed with their front and back surfaces in an alternate manner, there will be a lack of aesthetics. However, when both the first side 1a and the second side 1b are of the textured structure, it can be ensured that the light-facing side and the backlight side of the cell 10 present similar colors. Even if the cells 10 in the photovoltaic module are alternately disposed with their front and back surfaces in an alternate manner, the color consistency of the photovoltaic module may be maintained, thereby improving the aesthetics of the photovoltaic module.

As shown in FIG. 2, the cell 10 includes a first surface 10A and a second surface 10B oppositely distributed along the thickness direction Z of the cell 10. The first surface 10A may be a light-facing side of the cell 10 and is located on a same side as the first side 1a of the N-type silicon substrate 1. The second surface 10B may be a backlight side of the cell 10 and is located on a same side as the second side 1b of the N-type silicon substrate 1. The cell 10 includes a first electrode 5 disposed on the first surface 10A and a second electrode 6 disposed on the second surface 10B. The first electrode 5 may be a positive electrode of the cell 10, while the second electrode 6 may be a negative electrode of the cell 6. The first electrode 5 is located in the first region 10a. At least part of the structure of the first electrode 5 can penetrate through the first anti-reflection layer 7b and the first passivation layer 7a, and can be electrically connected to the boron-doped silicon structure 2. That is, the first electrode 5 and the boron-doped silicon structure 2 are only disposed in the first region 10a. The boron-doped silicon structure 2 can improve electrical conductivity, thereby ensuring that a good ohmic contact is formed between the first electrode 5 and the N-type silicon substrate 1, and thus reducing the series resistance. The second electrode 6 is located in the third region 10c. At least part of the structure of the second electrode 6 can penetrate through the second anti-reflection layer 8b and the second passivation layer 8a, and can be electrically connected to the phosphorus-doped conductive layer 3. That is, the passivation contact structure formed by the phosphorus-doped conductive layer 3 and the tunneling oxide layer 4, and the second electrode 6 are only disposed in the third region 10c. The passivation contact structure ensures that a good ohmic contact is formed between the second electrode 6 and the N-type silicon substrate 1, thereby reducing the series resistance.

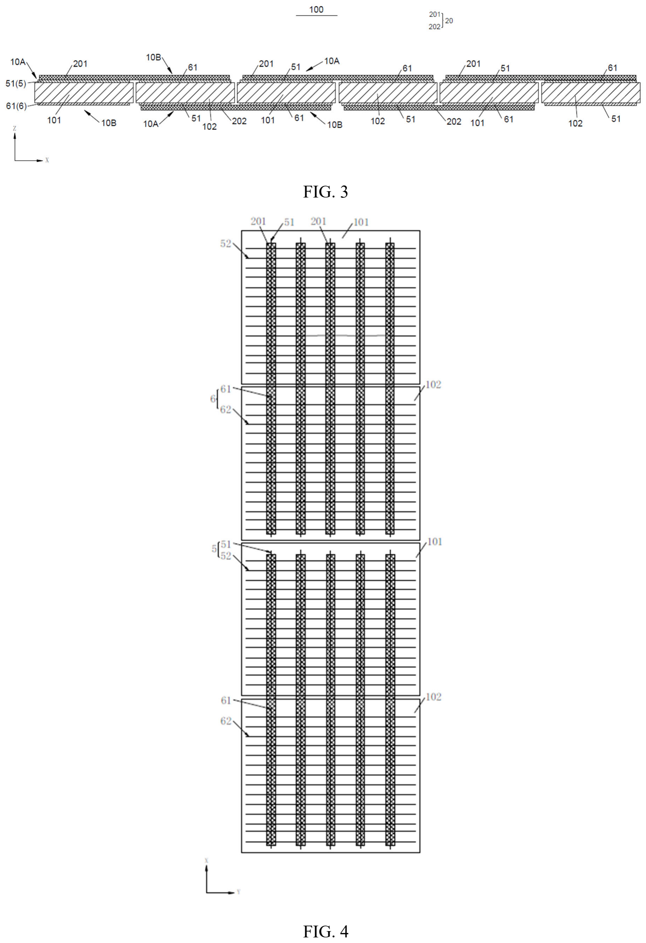

In this embodiment, the cell 10 includes a first cell 101 and a second cell 102. As shown in FIG. 3, along the length direction X of the cell strings 100, each of the cell strings 100 includes first cells 101 and second cells 102 disposed alternately. Along the thickness direction Z of the cell strings 100, first surfaces 10A of the first cells 101 and second surfaces 10B of the second cells 102 are located on a same side. That is, the first cell 101 and the second cell 102 are placed in opposite directions. The first electrode 5 of the first cell 101 is electrically connected to the second electrode 6 of the adjacent second cell 102 through the solder strip 20. The second electrode 6 of the first cell 101 is electrically connected to the first electrode 5 of the adjacent second cell 102 through the solder strip 20. The solder strip 20 includes first solder strips 201 spaced apart along the length direction X of the cell string 100 and second solder strips 201 spaced apart along the length direction X of the cell string 100. The first solder strips 201 and the second solder strips 202 are respectively located on two side surfaces along the thickness direction Z of the cell string 100. The first electrode 5 of the first cell 101 is connected to the second electrode 6 of the adjacent second cell 102 through the first solder strip 201. The second electrode 6 of the first cell 101 is connected to the first electrode 5 of the adjacent second cell 102 through the second solder strip 202.

In one or more embodiments, as shown in FIG. 3, taking the cell string 100 including six cells 10 as an example, along the length direction X of the cell string 100, the first cell 10 is the first cell 101, and the first surface 10A thereof is placed upward; the second cell 10 is the second cell 102, and the second surface 10B thereof is placed upward; the third cell 10 is the first cell 101, and the first surface 10A thereof is placed upward; the fourth cell 10 is the second cell 102, and the second surface 10B thereof is placed upward; the fifth cell 10 is the first cell 101, and the first surface 10A thereof is placed upward; and the sixth cell 10 is the second cell 101, and the second surface 10B thereof is placed upward. The first electrode 5 of the first cell 10 and the second electrode 6 of the second cell 10 are electrically connected through the first solder strip 201, the first electrode 5 of the second cell 10 and the second electrode 6 of the third cell 10 are electrically connected through the second solder strip 202, the first electrode 5 of the third cell 10 and the second electrode 6 of the fourth cell 10 are electrically connected through the first solder strip 201, the first electrode 5 of the fourth cell 10 and the second electrode 6 of the fifth cell 10 are electrically connected through the second solder strip 202, and the first electrode 5 of the fifth cell 10 and the second electrode of the sixth cell 10 are electrically connected through the first solder strip 201, thereby forming a complete cell string 100.

It should be noted that, when the cell string 100 includes more cells 10, which are also disposed in the foregoing manner, and a specific number of cells 10 in the cell string 100 is not limited in this embodiment. The first cell 101 and the second cell 102 have a same internal structure, while only differ in their disposed directions.

In the photovoltaic module provided in this embodiment, the cells 10 in the cell string 100 are disposed with their front and back surfaces in an alternate manner, enabling the solder strip 20 to connect two adjacent cells 10 via same-side interconnection, thereby reducing the cell spacing between adjacent cells 10 in the cell string 100, allowing an increase in the number of cells 10 in the cell string 100 without increasing the area of the photovoltaic module, reducing the blank area in the layout of the photovoltaic module, improving the light-receiving area of the cell string 100 per unit area, thus improving the power generation per unit area of the photovoltaic module and further improving the photoelectric conversion efficiency and the output power of the photovoltaic module. Additionally, the cell 10 in this embodiment adopts a special structure in which the first region 10a is provided with the boron-doped silicon structure 2 and the third region 10c is provided with the phosphorus-doped layer conductive layer 3, enabling the bifacial ratio of the cells to approach 100%, thereby further improving the photoelectric conversion efficiency of the photovoltaic module, and thus improving the output power of the photovoltaic module. Additionally, the use of same-side interconnection for the solder strip 20 may also avoid the bending of the solder strip 20, reduce the risk of the detachment of the solder strip 20, and lower the risk of stress concentration between the solder strip 20 and an edge of the cell 10, which is beneficial to improving the reliability of the photovoltaic module and prolonging the service life of the photovoltaic module.

In this embodiment, since the cells 10 in the cell string 100 are alternately disposed with their front and back surfaces in an alternate manner, the solder strip 20 can connect two adjacent cells 10 via same-side interconnection. That is, there is no traditional solder strip gap between adjacent cells 10, which can reduce the cell spacing between two adjacent cells 10. In one or more embodiments, a spacing between any one of the first cells 101 and the adjacent second cell 102 is smaller than 1mm. The spacing may be 0mm, 0.1mm, 0.2mm, 0.3mm, 0.4mm, 0.5mm, 0.6mm, 0.7mm, 0.8mm, 0.9mm or 1mm. When the spacing is 0mm, dense stacking of the cells 10 can be realized, thereby maximally increasing the power generation per unit area of the photovoltaic module and thereby improving the output power of the photovoltaic module.

It should be noted that, because the absolute zero spacing cannot be achieved in practical disclosures, as long as the measured value is smaller than 0.1mm, the spacing can be regarded as equivalent to 0 mm within the allowable error range of measurement work.

In one or more embodiments, the cell 10 may be a cell with a busbar. The first electrode 5 includes a first busbar 51 and a first finger 52. The first busbar 51 may be a busbar of a positive electrode. The first finger 52 may be a finger of a positive electrode. The second electrode 6 includes a second busbar 61 and a second finger 62. The second busbar 61 may be a busbar of a positive electrode. The second finger 62 may be a finger of a negative electrode. An extension direction of the first solder strip 201 is parallel to an extension direction of the first busbar 51 and the second busbar 61, and all are the length direction X of the cell string 100. The first solder strip 201 is configured to connect the first busbar 51 of the first cell 101 and the second busbar 61 of the adjacent second cell 102. An extension direction of the second solder strip 202 is parallel to an extension direction of the first busbar 51 and the second busbar 61, and all are the length direction X of the cell string 100. The second solder strip 202 is configured to connect the second busbar 61 of the first cell 101 and the first busbar 51 of the adjacent second cell 102. Along the width direction Y of the cell string 100, the first surface 10A of the cell 10 includes first busbars 51 spaced apart. The second surface 10B of the cell 10 includes second busbars 61 spaced apart. A number of the first solder strips 201 and the second solder strips 202 should be consistent with a number of the first busbars 51 and the second busbars 61, thereby ensuring the current collection effect of the first solder strip 201 and the second solder strip 202 for the cell 10.

In another embodiment, the cell 10 may be a busbar-free cell. The first electrode 5 only includes the first finger 52, and the second electrode 6 only includes the second finger 62. The extension direction of the first solder strip 201 is perpendicular to the extension direction of the first finger 52 and the second finger 62. The extension direction of the first solder strip 201 is the length direction X of the cell string 100, while the extension direction of the first finger 52 and the second finger 62 is the width direction Y of the cell string 100. The first solder strip 201 is configured to connect the first finger 52 of the first cell 101 and the second finger 62 of the adjacent second cell 102. The extension direction of the second solder strip 202 is perpendicular to the extension direction of the first finger 52 and the second finger 62. The extension direction of the second solder strip 202 is the length direction X of the cell string 100, while the extension direction of the first finger 52 and the second finger 62 is the width direction Y of the cell string 100. The second solder strip 202 is configured to connect the second finger 62 of the first cell 101 and the first finger 52 of the adjacent second cell 102. Along the length direction of the cell string 100, the first surface 10A of the cell 10 includes first fingers 52 spaced apart. The second surface 10B of the cell 10 includes second fingers 62 spaced apart. When the first solder strip 201 and the second solder strip 202 are connected to the cell 10, an electrical connection should be formed to each first finger 52 or each second finger 62 on a same cell 10. Additionally, first solder strips 201 and second solder strips 202 may be disposed along the width direction Y of the cell string 100 to improve the current collection effect of the first solder strips 201 and the second solder strips 202 for the cells 10.

## Claims

1. A photovoltaic module, comprising a cell string (100), wherein the cell string (100) comprises cells (10), the cells (10) comprise an N-type silicon substrate (1), the N-type silicon substrate (1) comprises a first side (1a) and a second side (1b) oppositely distributed along a thickness direction of the N-type silicon substrate (1), the first side (1a) comprises a first region (10a) and a second region (10b) distributed alternately, the first region (10a) is provided with a boron-doped silicon structure (2), the second side (1b) comprises a third region (10c) and a fourth region (10d) distributed alternately, and the third region (10c) is provided with a tunneling oxide layer (4) and a phosphorus-doped conductive layer (3) distributed in a stacked manner;
wherein one of the cells (10) comprises a first surface (10A) and a second surface (10B) oppositely distributed along a thickness direction of the cell (10), one of the cells (10) comprises a first electrode (5) disposed on the first surface (10A), and the first electrode (5) is only located in the first region (10a) and electrically connected to the boron-doped silicon structure (2); one of the cells (10) further comprises a second electrode (6) disposed on the second surface (10B), and the second electrode (6) is only located in the third region (10c) and electrically connected to the phosphorus-doped conductive layer (3);
wherein the cells (10) comprise first cells (101) and second cells (102), the first cells (101) and the second cells (102) are alternately disposed along a length direction of the cell string (100), and along a thickness direction of the cell string (100), first surfaces (10A) of the first cells (101) and second surfaces (10B) of the second cells (102) are located on a same side; and
wherein the cell string (100) further comprises a solder strip (20), the first electrode (5) of one of the first cells (101) is electrically connected to the second electrode (6) of one of the second cell (102) adjacent thereto through the solder strip (20), and the second electrode (6) of one of the first cells (101) is electrically connected to the first electrode (5) of one of the second cells (102) adjacent thereto through the solder strip (20).

2. The photovoltaic module according to claim 1, wherein the cell (10) is a whole cell, or a segmented cell.

3. The photovoltaic module according to claim 1, wherein the N-type doping element in the N-type silicon substrate (1) is one or a combination of phosphorus, arsenic or antimony.

4. The photovoltaic module according to claim 1, wherein the tunneling oxide layer (4) comprises at least one of silicon oxide, aluminum oxide, silicon nitride, silicon oxynitride, silicon carbide or magnesium fluoride, amorphous silicon or polysilicon.

5. The photovoltaic module according to claim 1, wherein the first side (1a) is a light-facing side of the N-type silicon substrate (1), and the second side (1b) is a backlight side of the N-type silicon substrate (1).

6. The photovoltaic module according to claim 5, wherein the first region (10a) is a metalized region of the light-facing side, and the second region (10b) is a non-metallized region of the light-facing side.

7. The photovoltaic module according to claim 1, wherein a spacing between each first cell (101) and a second cell (102) adjacent thereto is smaller than 1mm.

8. The photovoltaic module according to claim 1, wherein the solder strip (20) comprises a plurality of first solder strips (201) spaced apart along the length direction of the cell string (100), and the first electrode (5) of one of the first cells (101) is connected to the second electrode (6) of one of the second cells (102) adjacent thereto through the first solder strip (201); and
the solder strip (20) further comprises a plurality of second solder strips (202) spaced apart along the length direction of the cell string (100), and the second electrode (6) of one of the first cells (101) is connected to the first electrode (5) of one of the second cells (102) adjacent thereto through the second solder strip (202).

9. The photovoltaic module according to claim 8, wherein the first electrode (5) comprises a first busbar (51) and a first finger (52), and the second electrode (6) comprises a second busbar (61) and a second finger (62);
an extension direction of the first solder strip (201) is parallel to an extension direction of the first busbar (51) and the second busbar (61), and the first solder strip (201) is configured to connect the first busbar (51) of the first cell (101) and the second busbar (61) of the second cell (102) adjacent thereto; and
an extension direction of the second solder strip (202) is parallel to the extension direction of the first busbar (51) and the second busbar (61), and the second solder strip (202) is configured to connect the second busbar (61) of the first cell (101) and the first busbar (51) of the second cell (102) adjacent thereto.

10. The photovoltaic module according to claim 8, wherein the cell (10) is a busbar-free cell, the first electrode (5) comprises a first finger (52), and the second electrode (6) comprises a second finger (62);
an extension direction of the first solder strip (201) is perpendicular to an extension direction of the first finger (52) and the second finger (62), and the first solder strip (201) is configured to connect the first finger (52) of the first cell (101) and the second finger (62) of the second cell (102) adjacent thereto; and
an extension direction of the second solder strip (202) is perpendicular to the extension direction of the first finger (52) and the second finger (62), and the second solder strip (202) is configured to connect the second finger (62) of the first cell (101) and the first finger (52) of the second cell (102) adjacent thereto.

11. The photovoltaic module according to claim 1, wherein the phosphorus-doped conductive layer (3) is one of a phosphorus-doped amorphous silicon layer, a phosphorus-doped monocrystalline silicon layer, or a phosphorus-doped polycrystalline silicon layer.

12. The photovoltaic module according to claim 1, wherein the first surface (1a) is configured as a textured structure;
and/or, the second surface (1b) is configured as a textured structure.

13. The photovoltaic module according to claim 1, wherein the cell (10) further comprises a first passivation layer (7a) and a first anti-reflection layer (7b), the first passivation layer (7a) is disposed on a side of the boron-doped silicon structure (2) away from the N-type silicon substrate (1) and located in the second region (10b), and the first anti-reflection layer (7b) is disposed on a side of the first passivation layer (7a) away from the N-type silicon substrate (1).

14. The photovoltaic module according to claim 1, wherein the cell (10) further comprises a second passivation layer (8a) and a second anti-reflection layer (8b), the second passivation layer (8a) is disposed on a side of the phosphorus-doped conductive layer (3) away from the tunneling oxide layer (4) and located in the fourth region (10d), and the second anti-reflection layer (8b) is disposed on a side of the second passivation layer (8a) away from the N-type silicon substrate (1).

15. The photovoltaic module according to any one of claims 1 to 9, further comprising:
an encapsulation layer (200) configured to cover a surface of the cell string (100); and
a cover plate (300) configured to cover a surface of the encapsulation layer (200) away from the cell string (100).
